# EUROPÄISCHE PATENTANMELDUNG

(11) **EP 3 657 302 A1**
(43) Veröffentlichungstag der Anmeldung: **27.05.2020**
(21) Anmeldenummer: 18208293.3
(22) Anmeldetag: 26.11.2018
(51) Int. Cl.: G06F 3/02, G06F 3/044, H03K 17/955, H03K 17/96, G06F 3/0488

(54) **TASTATURABDECKUNG SOWIE KAPAZITIVE SCHALTVORRICHTUNG MIT EINER SOLCHEN**

(71) Anmelder: RAFI Systec GmbH & Co. KG, 88339 Bad Waldsee (DE)
(72) Erfinder: Zoll, Guido, 88361 Altshausen (DE); Widmann, Konrad, 88348 Kleintissen (DE); Dornheim, Peter, 88410 Bad Wurzach (DE)
(74) Vertreter: Engelhardt, Volker

(57) **Zusammenfassung**

Bei einer Tastaturabdeckung (11), die insbesondere auf einer Abdeckplatte (9) einer kapazitiven Schaltvorrichtung (1) anbringbar ist, soll durch die Tastaturabdeckung (11) die Abdeckplatte (9) der Schaltvorrichtungen flüssigkeitsdicht nach außen verschlossen sein, um Fehlfunktionen oder Störsignale ausgelöst durch Fremdpartikel, insbesondere Flüssigkeiten, zu vermeiden bzw. zu verhindern, ohne dass die Zuverlässigkeit der Bedienung solcher Schaltvorrichtungen verlorengeht.

Dies ist dadurch erreicht, dass die Tastaturabdeckung (11) aus einer Trägerschicht (12), in die eine Vielzahl von Aussparungen (14) eingearbeitet oder vorgesehen sind, und aus einer auf der Trägerschicht (12) aufgebrachten oder angeklebten Abdeckfolie (13) besteht, die aus einem transparenten und biegeelastischen Werkstoff hergestellt ist.

## Beschreibung

Die Erfindung bezieht sich auf eine Tastaturabdeckung, die insbesondere auf ein Gehäuse einer kapazitiven Schaltvorrichtung anbringbar ist sowie auf eine kapazitive Schaltvorrichtung nach dem Oberbegriff des Patentanspruchs 4.

Kapazitive Schaltvorrichtungen sind hinlänglich bekannt und werden beispielsweise als Maschine-Mensch-Schnittstelle in intelligenten Telefonen, Schaltflächen für Werkzeugmaschinen oder anderen elektrisch betriebenen Geräten eingesetzt. Üblicherweise sind die die Schaltvorrichtung bildenden Bauteile in einem Gehäuse wasser- oder luftdicht eingebaut, um das Eindringen von Verschmutzungen, Flüssigkeiten oder sonstigen den Betrieb der elektrischen Bauteile behindernde Partikel zu vermeiden. Zu diesem Zweck sind die elektrischen Bauteile durch ein Gehäuse und eine transparente Abdeckplatte nach außen verschlossen. Innerhalb des Gehäuses ist eine elektrische Leiterplatte vorgesehen, die mit einer Vielzahl von Sensoren bestückt ist. Mittels einer der Leiterplatte zugeordneten Steuereinrichtung werden die Sensoren mit elektrischer Energie versorgt, so dass diese ein elektrisches Feld ausbilden, das in Richtung der Abdeckplatte abgestrahlt ist.

Sobald beispielsweise ein menschlicher Finger in eines der von den Sensoren erzeugten elektrischen Felder eindringt, verändert sich die Kapazität des elektrischen Feldes, wodurch die Steuereinrichtung erkennt, dass eine Schaltfunktion in Bezug auf das entsprechende der jeweiligen Schaltfläche zugeordnete Steuersignal generiert ist. Die Abdeckplatte besteht nämlich aus einer Vielzahl von Schaltflächen, die fluchtend zu dem jeweils darunter angeordneten Sensor verlaufen.

Solche kapazitiven Schaltvorrichtungen haben sich in der Praxis in Umgebungen bewährt, die keinerlei störende Umwelteinflüsse erzeugen. Jedoch sind die kapazitiven Schaltvorrichtungen in Umgebungen mit entsprechenden Umwelteinflüssen äußerst störanfällig, denn die Abdeckplatte der Schaltvorrichtung kann verschmutzen, so dass die Schaltfunktion behindert oder gestört ist. Wenn zudem die Benutzer solcher Schaltvorrichtungen Handschuhe tragen, die aufgrund der maschinellen Bearbeitungsvorgänge mit Flüssigkeiten getränkt sind, können durch das Betätigen bzw. Berühren der Abdeckplatte Flüssigkeitstropfen auf die Oberfläche der Abdeckplatte gelangen und aufgrund der vorherrschenden Schwerkraft auf dieser herunterlaufen. Solche Flüssigkeitsrinnsale auf der Oberseite der Abdeckplatte führen allerdings oftmals zu Störsignalen und lösen eine nicht gewünschte Schaltfunktion aus.

Um solche Fehlbedienungen einer Werkzeugmaschine oder sonstiger mit der kapazitiven Schaltvorrichtung elektrisch gekoppelten Geräten zu verhindern, weist die Steuerelektronik der Schaltvorrichtung ein Fehlerprogramm auf, durch das die Schaltvorrichtung vollständig abgeschaltet wird, sobald die Steuereinrichtung solche Störsignale ausgelöst durch Flüssigkeitspartikel oder -rinnsale feststellt. Die Schaltvorrichtung ist anschließend von den Verunreinigungen zu befreien und neu zu starten. Solche Unterbrechungen führen sowohl zu einer unerwünschten Stillstandszeit der Maschine als auch zu zusätzlichen Arbeiten, die der Benutzer einer solchen Maschine vorzunehmen hat. Der Herstellungsprozess ist somit behindert und äußerst störanfällig aufgrund der vorherrschenden Verunreinigungen im Bereich der Werkzeugmaschine.

Es ist daher Aufgabe der Erfindung, eine Tastaturabdeckung für kapazitive Schaltvorrichtungen der eingangs genannten Gattung bereitzustellen, so dass die Abdeckplatte der Schaltvorrichtungen flüssigkeitsdicht nach außen verschlossen ist, um Fehlfunktionen oder Störsignale ausgelöst durch Fremdpartikel, insbesondere Flüssigkeiten, zu vermeiden bzw. zu verhindern, ohne dass die Zuverlässigkeit der Bedienung solcher Schaltvorrichtungen verlorengeht. Zudem soll die Tastaturabdeckung nachrüstbar für jede beliebige kapazitive Schaltvorrichtung sein und deren Herstellungskosten möglichst gering gehalten werden können.

Diese Aufgaben sind durch die Merkmale des kennzeichnenden Teils von Patentanspruch 1 sowie des kennzeichnenden Teils von Patentanspruch 4 gelöst.

Weitere vorteilhafte Weiterbildungen der Erfindung ergeben sich aus den Unteransprüchen.

Dadurch, dass die Tastaturabdeckung aus einer Trägerschicht, in die eine Vielzahl von Aussparungen eingearbeitet oder vorgesehen sind, und aus einer auf der Trägerschicht aufgebrachten oder angeklebten Abdeckfolie besteht, die aus einem transparenten und biegeelastischen Werkstoff hergestellt ist ist erreicht, dass eine Tastaturabdeckung entsteht, durch die beliebige kapazitive Schaltvorrichtungen Flüssigkeit dicht gekapselt werden können.

Wenn die erfindungsgemäße Tastaturabdeckung auf die Abdeckplatte einer solchen kapazitiven Schaltvorrichtung aufgebracht oder aufgeklebt ist, ist zunächst die Abdeckplatte flüssigkeitsdicht gekapselt und aufgrund der vorhandenen Abstände zwischen der Unterseite der Abdeckfolie der Tastaturabdeckung und der Oberseite der Abdeckplatte entsteht ein Luftpolster oder zumindest ein Luftspalt, so dass herunterfließende Flüssigkeiten oder sonstige Medien keine Fehlfunktion der darunterliegenden Schaltflächen auslösen, da der Abstand zwischen dieser und der Schaltflächen groß ist. Erst wenn eine manuelle Betätigungskraft auf die Oberseite der Abdeckfolie im Bereich der jeweiligen Schaltfläche einwirkt, wird die Abdeckfolie in Richtung der Schaltfläche bzw. der Abdeckplatte der Schaltvorrichtung durchgedrückt, so dass sich zunächst der Abstand zwischen der Abdeckfolie und der Schaltfläche bzw. der Abdeckplatte reduziert. Durch den ausgelösten Hubweg wird die Kapazität des elektrischen Feldes verändert, so dass ein Schaltsignal generiert ist, das von der Steuereinrichtung ausgewertet und zur Bedienung der daran angeschlossenen Werkzeugmaschine weitergeleitet ist.

Da die Abdeckfolie insbesondere aus einem geprägten Werkstoff hergestellt sein kann, entstehen im Bereich der Aussparungen der Trägerschicht flächige Erhöhungen oder Ausprägungen der Abdeckfolie, die eine rechteckförmige, runde,elliptische oder eine sonstige Außengeometrie aufweisen. Solche rechteckförmigen Erhöhungen der Abdeckfolie führen zum einen dazu, dass die Unterseite der jeweiligen Abdeckfolie im Bereich der Aussparungen der Tastaturabdeckungen von der Unterseite der Trägerschicht beanstandet ist und dass zum anderen ein Verstellweg für die jeweilige Abdeckfolie entsteht, wodurch eine Schalttaktik der Abdeckfolie bei deren Betätigung feststellbar ist. Zudem gewährleistet der Abstand zwischen der Abdeckfolie und der darunterliegenden jeweiligen Schaltfläche, dass Verunreinigungen nicht mehr in den Bereich des elektrischen Feldes gelangen und somit Störsignale bzw. ungewünschte Schaltvorgänge aufgrund von Verunreinigungen entfallen.

Um die Schalttaktiken der Abdeckfolie an gewünschte Einsatzzwecke anpassen zu können, sind in der Trägerschicht Luftkanäle eingearbeitet, die zwischen zwei Aussparungen verlaufen und diese miteinander verbinden. Demnach kann die zwischen der jeweiligen Abdeckfolie und der Abdeckplatte der Schaltvorrichtung eingeschlossene Luft aus den Luftkanälen entweichen und folglich entsteht kein Luftwiderstand während der Betätigung der Abdeckfolie in Richtung auf die Abdeckplatte der Schaltvorrichtung und es ist auch möglich, mittels einer Pumpe einen einstellbaren Überdruck in den von der Abdeckfolie, der Trägerschicht und der Abdeckplatte der Schaltvorrichtung eingeschlossenen Schaltkammern zu erzeugen, durch den die Schalthaptik bei der Betätigung der Abdeckfolie veränderbar ist. Es kann demnach ein unterschiedlicher Luftwiderstand gebildet sein, der unmittelbar auf die Bewegungsrichtung der Abdeckfolie einwirkt, so dass zwischen einer weichen und einer festeren Zustellbewegung - je nach gewünschter bzw. erforderlicher Schalthaptik - einstellbar ist.

Die Überbrückung des Schaltabstandes zwischen der Abdeckfolie und der Abdeckplatte kann zudem auch zusätzlich durch die Auswahl eines geeigneten Werkstoffes für die Trägerschicht ermöglicht sein, denn die Trägerschicht kann sowohl aus einem harten, also biegesteifen bzw. formstabilen oder einem weichen, also zusammendrückbaren Werkstoff hergestellt sein. Sobald demnach auf die Abdeckfolie eine manueller Betätigungs- kraft einwirkt, wird nicht nur die Abdeckfolie in Richtung der Abdeckplatte der Schaltvorrichtung bewegt, sondern vielmehr auch zusätzlich die Trägerschicht im Randbereich der Aussparungen zusammengedrückt. Dabei kann die Trägerschicht aus einem Polymer, beispielsweise Schaumstoff, gefertigt sein. Die Dichtfunktion der Trägerschicht, um wasser- oder sonstige Schmutzverunreinigungen von der Abdeckplatte der Schaltvorrichtung fernzuhalten, ist dabei von der Werkstoffauswahl nicht betroffen.

In der Zeichnung sind zwei Ausführungsbeispiele einer erfindungsgemäßen Tastaturabdeckung als Abdeckung für eine kapazitive Schaltvorrichtung dargestellt, die nachfolgend näher erläutert sind. Im Einzelnen zeigt:
- Figur 1: eine zweischichtige Tastaturabdeckung, die auf einer kapazitiv betriebenen Schaltvorrichtung aufgebracht ist, in perspektivischer Explosionsansicht,
- Figur 2: die Schaltvorrichtung gemäß Figur 1, im Schnitt und im betätigten bzw. unbetätigten Zustand der Tastaturabdeckung,
- Figur 3: ein erstes Ausführungsbeispiel der Tastaturabdeckung gemäß Figur 1 mit einer geprägten Abdeckfolie der Tastaturabdeckung und mit einem formstabilen Trägerelement, im betätigten und unbetätigten Zustand und
- Figur 4: ein zweites Ausführungsbeispiel der Tastaturabdeckung gemäß Figur 1 mit einer geprägten Abdeckfolie und einer Trägerschicht aus einem weichen Werkstoff, im betätigten und unbetätigten Zustand.

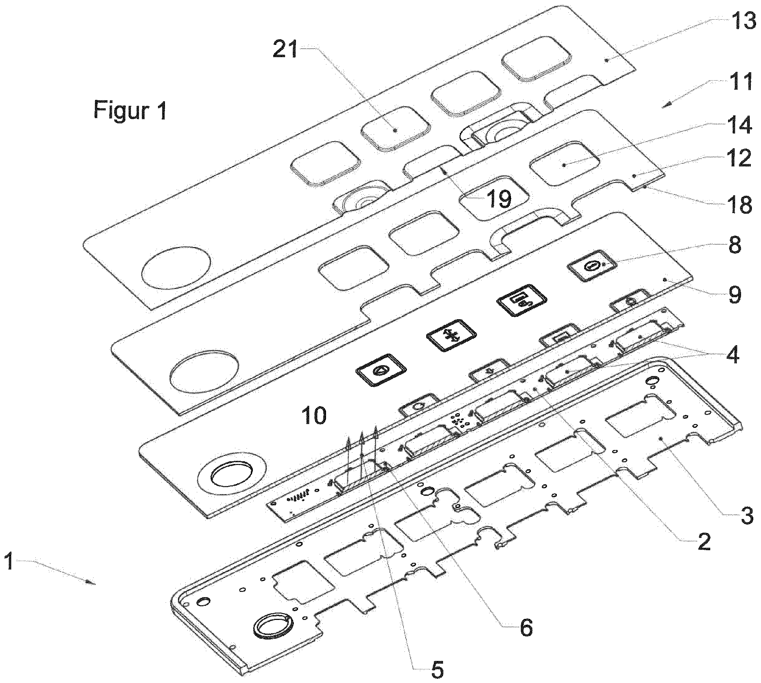

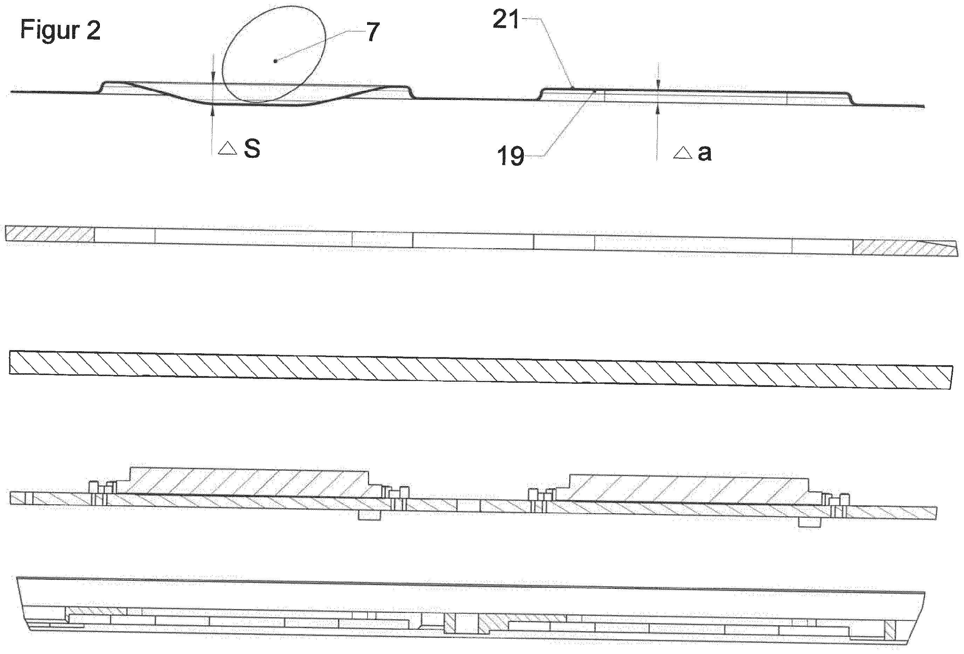

Aus den Figuren 1 und 2 kann eine kapazitiv betriebene Schaltvorrichtung 1 entnommen werden, durch die die Mensch-Maschine-Schnittstelle ein elektrisch betriebenes Gerät, beispielsweise ein Handy oder die Steuerelektronik einer Werkzeugmaschine betrieben ist. Solche kapazitiven Schaltvorrichtungen 1 bestehen üblicherweise aus einer Leiterplatte 2, die in einem Gehäuse 3 eingebaut ist. Auf der Leiterplatte 2 sind eine Vielzahl von elektrisch betriebenen Sensoren 4 angeordnet, durch die jeweils ein elektrisches Feld 5 erzeugt ist, das nach außen abstrahlt. Die Leiterplatte 2 ist mittels einer Abdeckplatte 9 aus einem transparenten und biegefesten Werkstoff verschlossen. Jeder Sensor 4 ist dabei einer Schaltfläche 8 zugeordnet, die graphisch auf der Unterseite der Abdeckplatte 9 aufgebracht oder mittels sonstiger elektrischer Hilfsmittel angezeigt ist. Sobald ein menschlicher Finger 7 in den Bereich des jeweiligen elektrischen Feldes 5 eindringt, ändert sich die Kapazität des elektrischen Feldes 5; solche Kapazitätsveränderungen können beispielsweise durch eine auf der Leiterplatte 2 angebrachten Steuereinrichtung 6 festgestellt und in ein Schaltsignal zur Steuerung eines elektrischen Gerätes umgewandelt sein.

Da die Abdeckplatte 9 von außen frei zugänglich ist, können auf deren Oberseite 10 Schmutzpartikel in Form von Flüssigkeitstropfen oder dergleichen auftreffen, wodurch sich die Kapazitäten der jeweiligen elektrischen Felder 5 verändern. Dies führt zwangsläufig zu ungewünschten Störsignalen bzw. Fehlschaltungen, durch die der Betriebsablauf einer Werkzeugmaschine oder des elektrischen Gerätes gestört und unterbrochen sind.

Um solche Fehlfunktionen der kapazitiven Schaltvorrichtung 1 zu verhindern, ist die erfindungsgemäße Tastaturabdeckung 11 vorgesehen, die aus einer Trägerschicht 12 und aus einer auf dieser aufgeklebten oder angeschweißten Abdeckfolie 13 gebildet ist. Die Abdeckfolie 13 ist dabei aus einem dünnen, biegeelastischen und transparenten Material oder Werkstoff hergestellt. Es ist besonders zweckmäßig, wenn die Abdeckfolie 13 Prägungen 21 aufweist, denn diese stehen aus der von der Abdeckfolie 13 gebildeten Ebene nach außen hoch. Die Ausprägungen 21 können eine rechteckförmige, runde, elliptische oder eine sonstige Außengeometrie aufweisen und sind jeweils einer in der Trägerschicht 11 eingearbeiteten Ausnehmung oder Aussparung 14 zugeordnet, so dass die Prägungen 21 der Abdeckfolie 13 fluchtend zu der jeweiligen Aussparung 14 der Trägerschicht 12 angeordnet sind. Die Ausprägungen 21 sind im dargestellten Ausführungsbeispiel flächig ausgestaltet, diese können ebenso nach außen gewölbt sein, so dass der Abstand Δa der Trägerschicht 12 vergrößert ist.

Aufgrund der Biegeelastizität der Abdeckfolie 13 kann diese in Richtung der fluchtend dazu angeordneten Schaltfläche 8 einen Hubweg Δs ausführen, während der Abstand Δa überwunden ist und deswegen eine Kapazitätsveränderung des elektrischen Feldes 5 entsteht.

Die Trägerschicht 12 weist einen Boden 18 auf, der wasserdicht auf der Abdeckplatte 9 der Schaltvorrichtung 1 aufgebracht oder aufgeklebt ist. Folglich ist die Abdeckplatte 9 durch die Trägerschicht 12 und die daran befestigte Abdeckfolie 13 wasserdicht bzw. flüssigkeitsdicht gekapselt, so dass flüssige Medien nicht mehr unmittelbar in Kontakt mit der Abdeckfolie 9 gelangen und folglich keine Kapazitätsveränderungen im Bereich der jeweiligen elektrischen Felder 5 entstehen bzw. auslösen können.

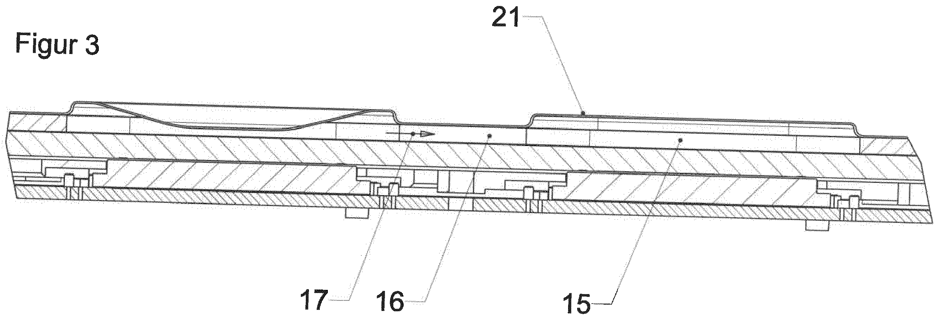

Aus Figur 3 ist ersichtlich, dass die Trägerschicht 12, die Abdeckfolie 13 und die darunter angeordnete Abdeckplatte 9 eine jeder der Schaltflächen 8 zugeordneten Schaltkammern 15 bilden, in denen ein Luftpolster vorhanden ist. Beim Zusammendrücken bzw. beim manuellen Betätigen der Abdeckfolie 13 wird dieses Luftpolster komprimiert, so dass der Innendruck des Luftpolsters die Schalthaptik der Abdeckfolie 13 beeinflusst. Darüber hinaus kann die Abdeckfolie 13 aus einem Geräusche verursachenden Material hergestellt sein, so dass nicht nur die Schalthaptik, sondern auch eine hörbare Betätigung der Abdeckfolie 13 entsteht.

Durch die Ausprägungen der Abdeckfolie 13 im jeweiligen Bereich der Schaltflächen 8 werden zudem auftreffende Partikel von der Schaltfläche 8 beabstandet, wodurch ein ungewolltes Auslösen oder Beeinflussen der Kapazität des jeweiligen elektrischen Feldes 5 verhindert ist.

Aufgrund der manuellen Krafteinwirkung auf die Oberfläche der Abdeckfolie 13 wird diese - wie in Figur 3 abgebildet - in Richtung der Abdeckplatte 9 und der jeweils darunter angeordneten Schaltfläche 8 bewegt. Die Abdeckfolie 13 ist demnach durch die manuelle Betätigungskraft in Richtung der Abdeckplatte 9 gewölbt und liegt auf dieser auf. Demnach kann die Abdeckfolie 13 aus der ausgeprägten Ausgangsposition in eine durchgedrückte Schaltposition durch die manuelle Betätigungskraft bewegt sein, so dass die Unterseite 19 der Abdeckfolie 13 in der von dem Boden 18 der Trägerschicht 12 gebildeten Ebene verläuft und unmittelbar auf der Oberseite 10 der Abdeckplatte 9 während der Betätigung aufliegt. Die Abdeckfolie 13 stört dabei das elektrische Feld 5 nicht; allerdings verändert der Finger 7 des Benutzers die Kapazität des elektrischen Feldes 5, wodurch wunschgemäß die Schaltsignale generiert sind.

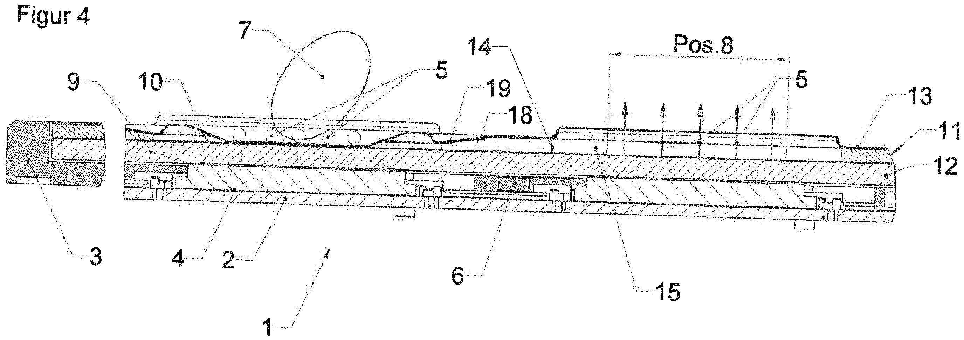

In Figur 4 ist eine weitere Ausgestaltung der erfindungsgemäßen Tastaturabdeckung 11 zu entnehmen. Dabei kann die Trägerschicht 12 aus einem weichen verformbaren Material hergestellt sein, so dass bei einer manuellen Betätigung der Abdeckfolie 13 nicht nur diese in Richtung der Abdeckplatte 9 bewegt ist, sondern dass auch der Randbereich der Trägerschicht 12 unmittelbar angrenzend zu der Prägung 21 der Abdeckfolie 13 zusammengedrückt ist.

Um die Schalthaptik der jeweiligen Schaltkammern 15 individuell einstellen zu können und/oder um den Luftwiderstand in den jeweiligen Schaltkammern 15 auf ein Minimum zu reduzieren, sind in der Trägerschicht 12 ein oder mehrere Luftkanäle 16 eingearbeitet, die jeweils in einer eine der Aussparungen 14 münden. Folglich sind die Aussparungen 14 über die Luftkanäle 16 miteinander gekoppelt, so dass ein größeres Innenvolumen entsteht und die zusammengedrückte Luft einen größeren Raum zur Verfügung hat, wenn die jeweilige Ausprägung 21 der Abdeckfolie 13 in Richtung der Abdeckplatte 9 bewegt ist. Das Luftpolster in den Schaltkammern 15 kann mithilfe einer Pumpe 17 auf einen bestimmten Innendruck eingestellt werden. Je höher der Innendruck in den Schaltkammern 15 ausgebildet ist, desto größer ist der Widerstand während der Betätigung der Abdeckfolie 13. Demnach kann eine relativ weiche bis zu einer härteren Haptik der Abdeckfolie 13 eingestellt sein.

Die Tastaturabdeckung 11 kann als nachrüstbarer Bausatz angeboten werden, so dass diese ebenso auf die bestehende Abdeckplatte 9 anbringbar ist.

Beispielhaft weist die Tastaturabdeckung 11 eine flächige Struktur auf; die Tastaturabdeckung 11 kann auch gebogen, gewölbt oder in einer beliebigen dreidimensionalen Struktur ausgestaltet sein, wenn die Abdeckplatte 9 eine solche aufweist.

## Patentansprüche

1. Tastaturabdeckung (11), die insbesondere auf einer Abdeckplatte einer kapazitiven Schaltvorrichtung (1) anbringbar ist,
**dadurch gekennzeichnet,**
**dass** die Tastaturabdeckung (11) aus einer Trägerschicht (12), in die eine Vielzahl von Aussparungen (14) eingearbeitet oder vorgesehen sind,
und aus einer auf der Trägerschicht (12) aufgebrachten oder angeklebten Abdeckfolie (13) besteht, die aus einem transparenten und biegeelastischen Werkstoff hergestellt ist.

2. Tastaturabdeckung (11) nach Anspruch 1,
**dadurch gekennzeichnet,**
**dass** zwischen dem Boden (18) der Trägerschicht (12) und der Unterseite (19) der Abdeckfolie (13) ein Abstand (Δa) vorhanden ist und dass der vorgegebene Hubweg (Δs) der Abdeckdeckfolie (13) und/oder die Elastizität der Trägerschicht (12) derart bemessen ist, dass der Abstand (Δa) zumindest bereichsweise überbrückbar ist und die Unterseite (19) der Abdeckfolie (13) aus der von dem Boden (18) der Trägerschicht (12) gebildeten Ebene in der von dieser gebildeter Ebene verläuft oder über diesen hinausragt.

3. Tastaturabdeckung nach Anspruch 1 oder 2,
**dadurch gekennzeichnet,**
**dass** die Abdeckfolie (13) zwei unterschiedliche Höhenniveaus aufweist, dass das erste Höhenniveau linear auf der Trägerschicht (12) flächig aufliegt und dass das zweite Höhenniveau als Ausprägung (21) ausgestaltet ist, die im Bereich der Aussparungen (14) fluchtend zu dieser verlaufen.

4. Kapazitive Schaltvorrichtung (1) als Mensch-Maschine-Schnittstelle bestehend aus
- einem Gehäuse (3), in dem eine Vielzahl von kapazitiv betriebenen Sensoren (4) vorgesehen sind, die vorzugsweise auf einer Leiterplatte (2) angeordnet sind und durch die jeweils eine Schaltfläche (8) mit einem elektrischen Feld (5) gebildet ist,
- aus einer Abdeckplatte (9) aus einem biegefesten und transparenten WerkStoff, durch die das Gehäuse (3) und die Schaltflächen(8) flüssigkeitsdicht verschlossen bzw. abgedeckt sind,
- und aus einer mit den Sensoren (4) jeweils elektrisch verbundenen Steuereinrichtung (6),
durch die Veränderungen des elektrischen Feldes (5) während der Annäherung eines Gegenstandes (7) an die jeweilige Schaltfläche (8) erfasst und zur Steuerung der Maschine ausgewertet sind,
**dadurch gekennzeichnet,**
**dass** die Abdeckplatte (9) mittels einer Tastaturabdeckung (11) nach einem der vorgenannten Ansprüche abgedeckt ist und dass jede Aussparung (14) in der Tastaturabdeckung (11) fluchtend zu einem der Schaltflächen (8) angeordnet bzw. ausgerichtet ist.

5. Schaltvorrichtung nach Anspruch 4,
**dadurch gekennzeichnet,**
**dass** zwischen der Unterseite (19) der Abdeckfolie (13) und der Oberseite (10) der Abdeckplatte (9) ein Abstand (Δa) in Form eines Luftpolsters im unbetätigten Zustand der Abdeckfolie (13) vorhanden ist und dass die Biegeelastizität der Abdeckfolie (13) und/oder die Werkstoffeigenschaften der Trägerschicht (12) eine Bewegung der Unterseite (19) der Abdeckfolie (13) in Richtung der Schaltfläche (8) ermöglichen.

6. Schaltvorrichtung nach einem der Ansprüche 4 oder 5,
**dadurch gekennzeichnet,**
**dass** die Trägerschicht (12) und die Abdeckfolie (13) mit der Abdeckplatte (9) eine Schaltkammer (15) luftdicht einschließen, die jeweils einer der Schaltflächen (8) der Schaltvorrichtung (1) zugeordnet ist.

7. Schaltvorrichtung nach einem der vorgenannten Ansprüche 4 bis 6,
**dadurch gekennzeichnet,**
**dass** in dem Boden (18) der Trägerschicht (12) ein zwischen zwei benachbarten Aussparungen (14) ein Luftkanal (16) eingearbeitet ist, der jeweils in eine der Aussparungen (14) mündet.

8. Schaltvorrichtung nach einem der Ansprüche 4 bis 7,
**dadurch gekennzeichnet,**
**dass** die Abdeckfolie (13) eine Vielzahl von Aussparungen (21) aufweist, die aus der von dieser gebildeten Ebene abstehen und fluchtend zu den Aussparungen (14) der Trägerschicht (12) und der jeweiligen Schaltfläche (8) verlaufen.

9. Schaltvorrichtung nach Anspruch 8,
**dadurch gekennzeichnet,**
**dass** die Ausprägungen (21) eine rechteckförmige, runde, elliptische oder sonstige Außengeometrie aufweisen.

10. Schaltvorrichtung nach Anspruch 7,
**dadurch gekennzeichnet,**
**dass** die Luftkanäle (16) und die Aussparungen (14) an einer Pumpe (17) angeschlossen sind, und dass der von der Pumpe (17) erzeugte Luftdruck in den Luftkanälen (16) und in den Schaltkammer (15) der Bewegung der Abdeckfolie (13) entgegenwirkt.
